# EUROPEAN PATENT SPECIFICATION

(11) **EP 3 547 354 B1**
(45) Date of publication and mention of the grant of the patent: **30.12.2020**
(21) Application number: 19176222.8
(22) Date of filing: 24.06.2016
(51) Int. Cl.: H01L 21/67

(54) **METHOD OF USE OF A PRESSURIZED HEATED ROLLING PRESS**
VERFAHREN ZUR VERWENDUNG EINER UNTER DRUCK STEHENDE WALZENPRESSE
PROCÉDÉ D'UTILISATION D'UNE PRESSE À ROULEMENT CHAUFFÉ SOUS PRESSION

(30) Priority: 25.06.2015 US 201562184712 P; 23.06.2016 US 201615191410
(43) Date of publication of application: 02.10.2019
(62) Document number(s) of the earlier application(s) in accordance with Art. 76 EPC: 16741433.3 / 3 314 640
(73) Proprietor: Alta Devices, Inc., Sunnyvale, CA 94085 (US)
(72) Inventor: Sorabji, Khurshed, Sunnyvale, California 94085 (US)
(74) Representative: Boult Wade Tennant LLP

(56) References cited:
- WO-A1-2007/080822
- WO-A1-2014/046810
- JP-A- 2006 120 998

## Description

### FIELD OF THE INVENTION

The present invention relates generally to manufacturing techniques involving assemblies and more particularly to an improved method of manufacturing an assembly including higher-yielding cell feeders, a pressure-controlled thermal treatment process and apparatus, and an improved assembly process for a high throughput system.

### BACKGROUND OF THE INVENTION

Manufacturing processes which involve the assembly of components can be performed manually, automatically, or in combination, often in relation to the complexity of the manufacturing process. For instance, assembly processes that press a first component to a second component in a gluing operation often require compression resulting from force on the first component to the second component where an adhesive is affixed in advance in between. The steps involved in this basic assembly process can be simple or complex, in relation to the sensitivity, characteristics and nature of the components as well as the environment of the process itself. One method may involve a manual effort using a hand-guided light touch to press a first component onto the second to ensure that neither component is damaged based upon the experience of the operator manually performing the process. Another method may involve an automated robot device that is able to lift a first component from a tray and then align the first component over a second component having an adhesive coating, and press the first component onto the second component in relation to a control algorithm. Manual processes are often more difficult in environments that are caustic and high temperature, and often automated processes are difficult in processes that have delicate or sensitive components involved. Similarly, manual processes often are lower yield producing for higher-value components and automated processes having higher yields are often for lower-valued components. What is desired is an improvement to manufacturing processes that may produce higher yields of assembly where the assemblies include higher-valued and often sensitive components.

Often in the manufacturing of photovoltaic solar cells and photovoltaic solar cell components into photovoltaic devices such as solar mats, multiple laminate layers are applied to a carrier plate where both the contact and alignment are required to be precise and within particular pressure ranges as the components for example, solar cells are sensitive such that they may be easily broken or damaged during manufacture. As a result, often portions of assembly are manual with lower yields. Additionally, certain follow-on steps of the assembly process often involve high temperatures for curing the cell assemblies in which manual involvement may be dangerous or in some situations, impossible. As yields are sought to be improved, often more automated approaches are introduced which then create additional breakage or damage to the components during assembly, or in other situations, require additional steps to the existing processes which do not substantially reduce the processing times.

In WO 2014/046810 there is described a system that generally comprises a first conveyor including a receptacle configured to receive a photovoltaic (PV) cell module preassembly; a vacuum applicator; a pressure applicator; a curing applicator; and a second conveyor. The second conveyor is arranged opposing the first conveyor to seal the receptacle, and is configured to function as a press bladder for the pressure applicator. The vacuum applicator, the pressure applicator, and the curing applicator are configured to respectively process the PV cell module preassembly at spatially distinct positions of the receptacle. The first or second conveyor is configured to transport the receptacle from position to position from the vacuum applicator to the pressure applicator and from the pressure applicator to the curing applicator. The system is configured and operable to form a cured PV cell module. A method is also described that employs the system to press cure PV cell module preassemblies to prepare cured PV cell modules.

In JP 2006 120998 there is described a manufacturing apparatus that comprises a positioning belt, a deliverably adjacent heating belt, and a retain belt opposite the positioning belt and the heating belt so as to bridge across both; and controls both the heating belt and the retain belt at specified temperatures. Guide grooves corresponding to the shape of an inter-connector are formed in the outer sides of both belts. A method of manufacturing a solar cell module uses the apparatus, and has a step of firmly holding a solar battery cell and the inter-connector with the heating belt and the retain belt and soldering with the inter-connector shed in both guide grooves while carrying them.

In WO 2007/080822 there is described a connection method and a connection apparatus capable of preventing cracking and warpage due to heat stress and improving the yield even when an ultra-thin element substrate is used in connecting a solar cell element by means of TAB-lead soldering. When the fusion bonding of a TAB lead is finished in a fusion bonding zone for fusion-bonding solder, a workpiece is moved from the fusion bonding zone and carried through each of the subsequent three cooling zones by carrying belts. Above the carrying belt of each cooling zone is provided a pressing plate that has a pressing pad elevatable by an air cylinder and controlled at a predetermined temperature through a cooling plate and cools the fusion-bonded part pressed with the pressing pad. Closely below the carrying belt is provided a lower cooling plate whose temperature is electrically controlled.

Nonetheless, with demand for photovoltaic cells increasing and the utility of the cells being incorporated into more commercial opportunities in varied markets worldwide, there is a need for improvements to the standard manufacturing assembly processes, in the photovoltaic cell area as well as other assembly areas, to improve the yield without increasing damage to sensitive components, to reduce the risks to those involved in the manual processes while incorporating an approach having a lighter-touch in the assembly process, and to reduce the time to process steps in the assembly, safely.

### SUMMARY OF THE INVENTION

According to the present invention there is provided a method having the features of claim 1 for connecting a plurality of materials using pressure and thermal curing.

In one embodiment a method for connecting a plurality of materials using pressure and thermal curing comprises receiving the plurality of materials on the vacuum conveyor at a first location wherein the vacuum conveyor includes a plurality of openings for a predetermined vacuum pressure to hold the plurality of materials in place on the vacuum conveyor; conveying the received plurality of materials from the first location to a second location along the vacuum conveyor, where a moving belt is adaptively positioned above the vacuum conveyor at the second location and the vacuum conveyor and the moving belt are arranged to be driven in a predetermined relation to one another; and applying a predetermined vacuum pressure from at least one of the plurality of openings towards the moving belt and the vacuum conveyor as the plurality of materials are conveyed from the second location to a third location, creating a force compressing the plurality of materials; and curing the compressed plurality of materials.

There is also described a system for connecting a plurality of materials using pressure and curing that comprises a flexible component feeder source for providing the plurality of materials at first location; a vacuum conveyor for receiving the plurality of materials at the first location wherein the vacuum conveyor includes a plurality of openings for a predetermined vacuum to hold the plurality of materials in place on the vacuum conveyor; a moving belt that is adaptively positioned above the vacuum conveyor at a second location, the vacuum conveyor and the moving belt being arranged to be driven in a predetermined relation to one another for conveying the received plurality of materials from the first location to a second location along the vacuum conveyor; a vacuum pressure source for applying a predetermined vacuum pressure from at least one of the plurality of openings towards the moving belt and the vacuum conveyor as the plurality of materials are conveyed from the second location to a third location, creating a force compressing the plurality of materials; and a curing source at a second location for curing the compressed plurality of materials.

There is also described a flexible component feeder source comprising a flexible base suitable for protecting and receiving one or more photovoltaic cells for processing. The feeder source, in a preferred arrangement, includes a base having a linear shape when opened and forms a roll when rolled.

### BRIEF DESCRIPTION OF THE SEVERAL VIEWS OF THE DRAWINGS

The drawings referenced herein form a part of the specification. Features shown in the drawings are meant as illustrative of only some embodiments of the invention, and not of all embodiments of the invention, unless otherwise explicitly indicated, and implications to the contrary are otherwise not to be made.
FIG. 1 diagrams illustratively an approach for processing photovoltaic cells.
FIGs. 2A and 2B diagram a flexible tape feeder having a plurality of photovoltaic cells.
FIGs. 2C and 2D depict two methods for holding the photovoltaic cells in the tape feeder.
FIG. 3 diagrams a method of processing photovoltaic cells in accordance with one or more embodiments of the present invention.
FIG. 4 diagrams a vacuum conveyor and a moving belt in relation arrangement.
FIG. 5 diagrams a vacuum conveyor and a moving belt in relational arrangement when under pressure from a vacuum source such as a vacuum pump creating a downward pressure.

### DETAILED DESCRIPTION

The following detailed description is not to be taken in a limiting sense, and the scope of the invention is defined only by the appended claims.

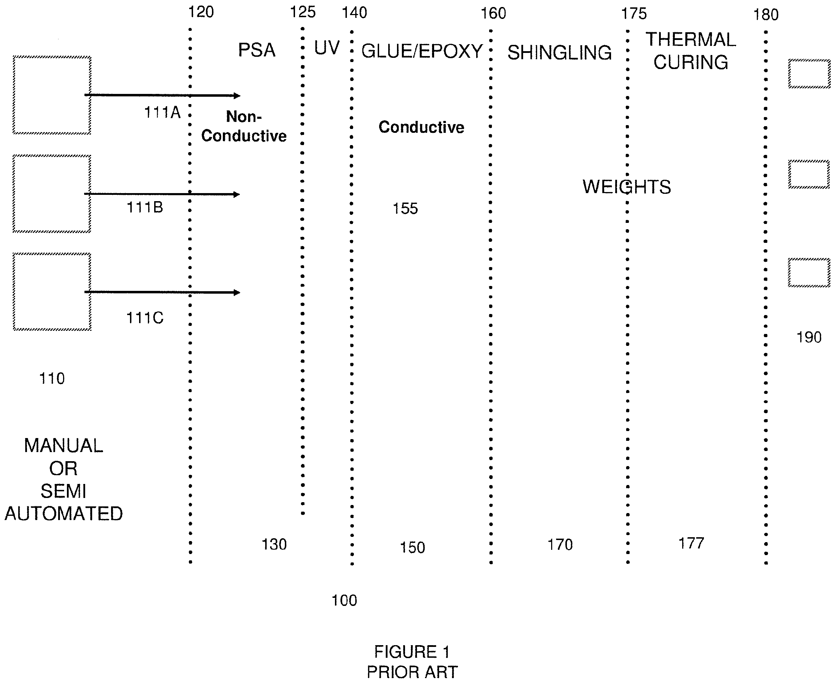

FIG. 1 diagrams illustratively an approach 100 for processing photovoltaic cells. From FIG. 1, a series of stacked cells 110 is located at the source of the approach 100 where each cell component is stacked in position to be processed in accordance with one of three processing lanes, 111A, 111B and 111C. Typically, the stacked cell components may be manually removed from the stacking and placed on a moving conveyor for processing. The stacked cells are often referred to as a 'coin stack' due to their physical arrangement. Human intervention is often necessitated due to the possibility of damage to the cells and the difficulty of the alignment of sensitive components by automated devices. Human intervention is also often necessitated as the cells are typically sticky or may have other material surface issues that require additional care in separating out the individual cells from one another in the coin stack. In certain situations, some automated equipment may be used in a limited manner though it should be realized that this process is typically a low speed process resulting in less than 10 parts per hour.

Once the components are aligned, the process proceeds to 120. At 120, the cells are prepared for a pressure sensitive adhesion (PSA) step. The PSA step 130 may involve application of a pressure sensitive adhesive which, when the component is placed into contact with another component or material, creates a bond wherein each of the two parts are securely affixed to one another. Once the PSA step is completed, the cells move to 125 for UV curing which may comprise curing using ultra-violet (UV) light (i.e., a UV-cure tunnel).

At 140, the cells then move to a gluing step at 150. In some situations, one side of a cell may have adhesive applied to it, in other situations, adhesive may be applied to one or more component parts. Glue may be applied by hand or by equipment though the latter is often difficult. Once the gluing step is completed, the cells move to a shingling step 160.

At shingling step 160, the cells are coupled together through preferably a shingling process 170. The shingling process involves connecting the photovoltaic cells together. Examples of this process are described in US Patent Publication No. 2013/0206213.

It is typical to place weights or apply other physical devices, such as rollers, to at least one of the component portions in order to create a secure bond between the two components. Using weights at 175, while typical, creates additional risks as the use of weights may cause sensitive components to be damaged or require further hardware replacement during operations which may be difficult or expensive. Alternatively, it is also known to use clamps to achieve a similar effect.

At 175, the cells are prepared for the curing step. The curing step 177 may involve ovens, and other thermal or light-based processes. Once the curing step is completed, the cell then moves to 180. At 180, the processing is completed for the affected photovoltaic cell and the completed photovoltaic cell results at 190.

As used herein, the term 'components' and 'materials' may include Gallium Arsenide (GaAs) based components or other photovoltaic components such as photovoltaic cells for example, flexible, thin-film photovoltaic devices comprising semiconductor material, which may or may not be single-crystal, including but not limited to Group III-V materials such as GaAs, AIGaAs, InGaAs, AllnGaAs, InGaAsP, InGaP, AllnGaP, and AllnP (and combinations thereof); Group IV materials such as Si, amorphous Si, Ge, SiGe; Group II-VI materials such as CdTe; other materials such as CIGS (Copper indium gallium (di)selenide), perovskites such as lead halides, organic semiconductors, CZTS, CZTSSe, and dye-sensitized photovoltaic absorber materials, and will typically be layered arrangements of materials which have one or more interface layers that promote a fixed arrangement as between the material layers following a processing sequence.

Examples of such materials, without limitation, may include photovoltaic cells, solar cells, solar panels, layered plastic components, electronic components, high density interconnects, chips, chips on flex, mixed composition materials having multiple layers arranged to be securely arranged with one another, and combinations thereof, for instance.

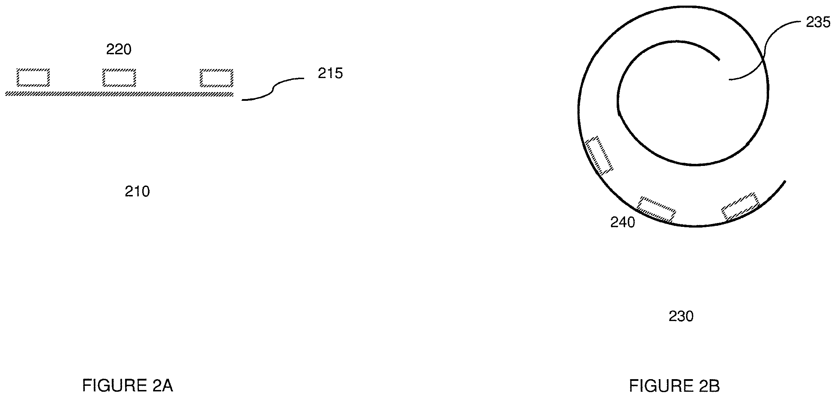

FIGs. 2A and 2B diagram a flexible tape feeder 210 having a plurality of photovoltaic cells 220 in connectable arrangement with the tape base 215. The tape feeder, or tape carrier, provides a source of components to be fed into the assembly or process. The flexible tape feeder also provides a flexible backing to flexible cells to be assembled thereby reducing damage to the cells during the feeding process. The use of the tape feeder is preferred over the coin stacking method as the tape feeder provides a reuse aspect, is more protective of the sensitive components arranged thereon, and is more efficient in the assembly operation. The flexible tape feeder may comprise any of polyethylene terephthalate (PET), porous materials including paper, cloth and a combination thereof.

Traditional operations use a coin stacking approach which requires a larger footprint in the assembly process and also does not protectably secure the sensitive devices to be processed. The tape feeder provides a linear flexible base 215 in which sensitive components 220 may be situated, protectively, for processing in the assembly process. The flexible base is of a linear shape when opened and forms a roll when rolled. Alternatively, the flexible base is of linear shape when under taught tension and retracts to a coil shape when tension to the base is absent.

In one arrangement, the linear base of the tape feeder at 230 may be arranged to provide for a coiling capability 235 where once a tape is populated with a plurality of sensitive components 240, the tape may be wound into the shape of a coil or roll. The coiled tape may then be placed at the beginning of the assembly process whereafter humans and/or robots may readily access the sensitive components situated thereon, removing them for processing. As the tape is fed for the process, the coiled arrangement requires less space and the tape may be rolled into a reusable stock tape during the process as each component is removed.

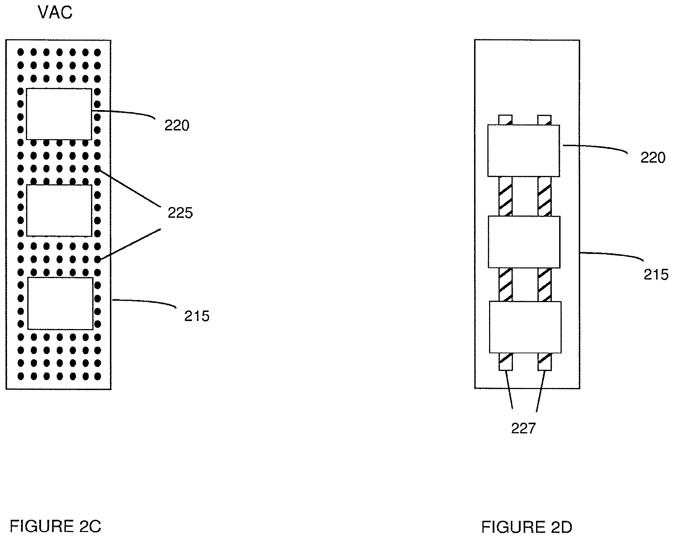

In one arrangement, a width of the flexible base is approximately similar to a size of the photovoltaic cells. In one or more preferred arrangements, instead of a few active lines of processing from traditional stacked cell arrangements involving trays, coin stacking and the like, the present arrangement provides for a six lane processing arrangement using only three tape rolls of components in which a single tape roll can be used to feed a plurality of active processing lanes. In this manner, the use of the tape feeder also promotes a higher speed operation over the traditional approach. The photovoltaic cells can be carried by the tape feeder in a variety of ways. FIGs. 2C and 2D depict two methods for holding the photovoltaic cells in the tape feeder. In a first arrangement shown in Figure 2C a vacuum is applied through the openings 225 in the linear base 215 to hold the photovoltaic cells 220 in place.

In a second arrangement shown in Figure 2D adhesive strips 227 on the linear base 215 are utilized to hold the photovoltaic cells 220 in place. One of ordinary skill in the art readily recognizes that either one or both of the methods together can be utilized to hold the photovoltaic cells 220 in place. For example, in one arrangement, the linear base can use a combination of strategically placed openings 225 and strategically placed adhesive strips 227 and that would be within the scope of the present invention. In an alternate arrangement, various other materials such as, but not limited to, adhesive pads, adhesive tape, glue, PSA, a mechanism to hold the photovoltaic cells in place or a combination of such materials/mechanisms can be used to hold the photovoltaic cells in place.

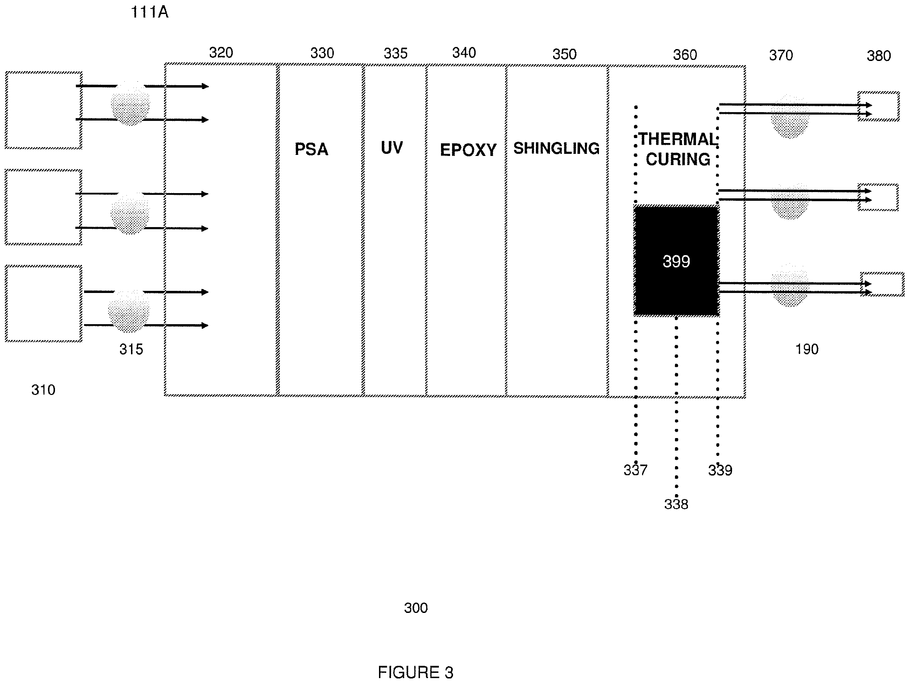

FIG. 3 diagrams a method 300 of processing photovoltaic cells in accordance with one or more embodiments of the present invention. A tape feeder, described above, is situated at the beginning of a preferred assembly method at 310 as shown in FIG. 3. Preferably, automated equipment 315 removes the sensitive components (or materials) situated on the tape feeder and places them in a predetermined arrangement on the conveyor for processing at 320 corresponding to element 111A shown in Figure 1. In one or more preferred embodiments, the automated equipment may stack two components that are to be securely arranged together atop one another, next to one another, or proximate to one another. The components are then prepped for the next phase of processing, which for the exemplary purposes of FIG. 3 is a phase of receiving a PSA treatment at 330. At 330, the components are prepared and are arranged in layered form with an adhesive based interface between the arranged components as a layered component. The PSA step 330 may involve application of a pressure sensitive adhesive which, when the component is placed into contact with another component or material, creates a bond wherein each of the two parts are securely affixed to one another. Once the PSA step is completed, the cells then move to 335 for UV curing which may comprise curing using ultra-violet (UV) light (i.e., a UV-cure tunnel).

At 340, conductive epoxy, for example, is placed on one or more sides of at least one component to be processed and the components are arranged before the next step of shingling the components.

Thereafter the prepared photovoltaic cells are coupled together via shingling process 350. In one or more embodiments of the present invention, the next phase is a curing step in which an oven, conventional oven, convection oven, lamp-based source, or thermal source is used, though other possibilities are also envisioned by the present invention. Curing could also be done by other methods, including but not limited to UV exposure, or evaporation of the solvent in air or in a vacuum, for example.

The layered component is then conveyed along a conveyor for thermal curing without the use of physical pressure plates or devices. At 360, the layered component will traverse from a first location 337 to a second location 338 where at the second location the upper portion of the layered component will be under pressure from a surface of a moving belt in adaptable contact with the upper portion.

At the first location 337, the layered component is situated on the conveyor which is a vacuum conveyor having a plurality of openings therein. Preferably the vacuum conveyor is also comprised of a durable material that provides rigidity and flexibility under pressure, such as being at least partly comprised of metal (SST, Al, etc.), high temp plastic, ceramic, granite, etc.. As the layered material traverses from the first location to the second location, a moving belt is situated above the conveyor and above the layered component. The moving belt can be an idler belt or a driven belt situated above the conveyor and above the layered component. In one arrangement, the moving belt is not in contact with the layered component at the first location 337 but is in contact with the layered component at approximately the second location 338 and for a period of travel proximate thereto depending on the physical arrangement in one or more preferred arrangements. A pressure source, such as an air pump, vacuum pump, or pressurized air flow is positioned proximate to the idler belt or the driven belt and is adaptable and adjustable to control the flow of air from the air source to and across the idler belt or the driven belt and the vacuum conveyor, at 360. In one or more embodiments, a vacuum pump is controlled by a controller in which there are multiple zones of varying pressure between the second location 338 and a third location 339, for example.

At approximately the second location 338, in one or more preferred embodiments, the idler belt is in contact with the upper portion of the layered material. In operation, when no air pressure is provided from the air source, the idler belt will be in 'non-pressured' contact with the upper surface of the layered material, resulting in the idler belt rolling at the same speed to that of the layered component due to the friction created. However, in operation, when there is active air pressure provided from the air source, the idler belt will be in 'pressured' contact with the upper surface of the layered material, resulting in the idler belt applying a pressure force to the upper portion of the layered material thereby forcibly pressuring the upper portion onto the lower portion. The rolling speed of the idler belt will act resistively towards the layered material though the speed may approximate a speed similar to that of the layered component due to the friction created. The idler belt will remain in non-pressured or pressured contact with the upper portion of the layered component until the layered component reaches the third location at 339. The user is able to adaptably adjust the amount of pressure a layered component receives based on the air source, the length of contact with the idler belt, and the environmental conditions of the process.

In an embodiment, the movement of the moving belt is controlled in relation to the time and pressure required for cure. Similarly, a speed of conveyance of the vacuum conveyor, a speed of operation of the moving belt, a material composition of the vacuum conveyor, a material composition of the moving belt, and a length of travel the vacuum conveyor and the moving belt traverse between the second location and the third location is dependent upon temperature and time required for curing. In an embodiment, the moving belt can be an idler belt or a driven belt situated above the conveyor and above the layered component.

At the third location 339, the layered materials have been situated together based on the pressured or non-pressured contact. Depending on the layered materials of the process, the curing time of phase 360 may differ substantially and may also depend on the user's interest in achieving a full or partial cure for the layered material. For instance, where the layered materials are photovoltaic cells, the method of the present invention provides that approximately one minute per cell matrix would be a reasonable estimate of the curing time required, with a slightly longer time being required if a plurality of matrices is placed in parallel for instance, by example.

After the curing phase at 360, the finished layered components are cooled from the phase of curing, via active or passive cooling and are removed preferably by automated equipment at 370 corresponding to element 190 shown in Figure 1. For clarity, while use of automated equipment is discussed and preferred in certain applications of the present invention, it is not required as the present invention is also capable of being operated without automated equipment and in an arrangement that is partly automated equipment and partly human interaction, without limitation.

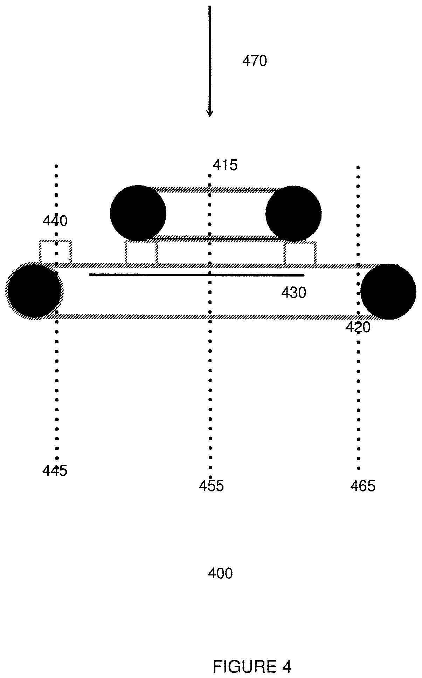

FIG. 4 diagrams a vacuum conveyor 420 and a moving belt 415 in relational arrangement at 400. The moving belt can be an idler belt or a driven belt situated above the conveyor and above the layered component. As shown in FIG. 4, a multi-layer component is entering the drive arrangement 400 at 440 at a first location 445. The multi-layer component is situated on the conveyor (i.e., vacuum conveyor) 420 and is conveyed to a second point 455. At the second location 455, the moving belt 415, for example, an idler belt, may be situated to be in non-pressurized or pressurized contact with the upper portion of the multi-layered component. After possible contact at the second location 455, the multi-layer component is continued to be conveyed along the vacuum conveyor to a third location 465.

As shown in FIG. 4, the vacuum conveyor 420 and the idler belt 415 may be driven by the same motor drive or controller; in another arrangement, the vacuum conveyor 420 and the idler belt 415 are driven independently. In a preferred arrangement the vacuum conveyor 420 is fabricated from steel. In a further preferred arrangement, a pressure plate is present at 430 which provides additional support to layered components on the surface of the vacuum conveyor 420 during a pressurized air flow.

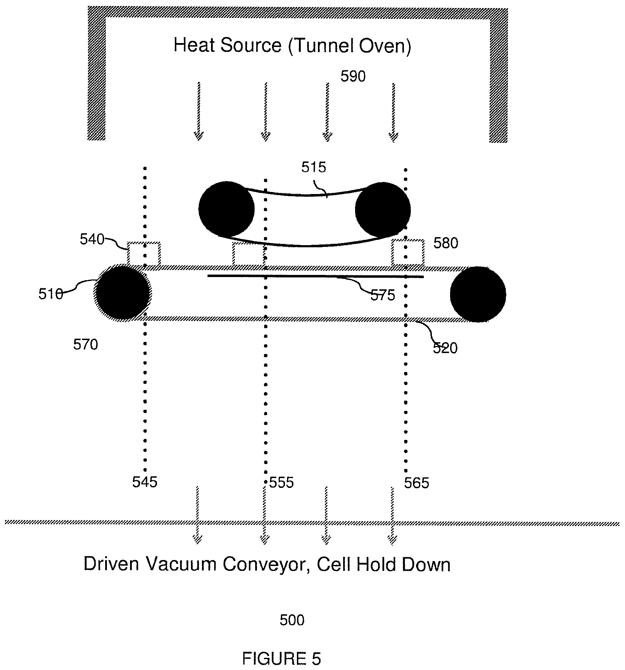

FIG. 5 diagrams a vacuum conveyor 520 and a moving belt 515 in relational arrangement at 500 when under pressure from a vacuum source such as a vacuum pump creating a downward pressure. The moving belt can be an idler belt or a driven belt situated above the conveyor and above the layered component. As shown in FIG. 5, a multi-layer component 540 is entering the drive arrangement 510 at a first location 545. The multi-layer component 540 is situated on the conveyor system (i.e. vacuum conveyor) 520 and is conveyed to a second location at 555. At the second location, the idler belt 515, in the example, is under pressure from a vacuum pump creating a pressurized force downwards such that the upper portion of the multi-layered component 540 is in contact with the idler belt 515. As the multi-layered component 540 is conveyed from the second location 555, the idler belt 515 applies pressure to the upper portion and the upper portion is compressed onto the lower portion which continues to ride along the vacuum conveyor 520 above a reinforcing plate preferably situated at 575, between the second location 555 and the third location 565. The force of the pressure may be adjusted by varying the vacuum pump, etc.. After contact at the second location 555 and thereafter, the multi-layer component 540 is continued to be conveyed along the vacuum conveyor to the third location 565 where the contact to the upper portion from the idler belt 515 ceases and the compressed multi-layered component 540 is at a final stage at 580.

In one example, the top of the arrangement 500 is heated by a tunnel oven 590 while the bottom of the arrangement 500 may either be heated, unheated or actively cooled as required by the process. In such an example, temperature may be used to also facilitate the pressure adhesion process.

In operation, when there is no air pressure provided from the air source (or vacuum source), the idler belt will be in 'non-pressured' contact with the upper surface of the layered material, resulting in the idler belt rolling at a speed approximately similar to that of the layered component due to the friction created. In another arrangement, the idler belt is in adjustable contact with the upper portion based upon physical arrangement and air source pressure such that there is no contact with the upper portion absent an air source.

In one arrangement, the movement of the moving belt is controlled in relation to the time and pressure required for cure. Similarly, a speed of conveyance of the vacuum conveyor, a speed of operation of the moving belt, a material composition of the vacuum conveyor, a material composition of the moving belt, and a length of travel the vacuum conveyor and the moving belt traverse between the second location and the third location is dependent upon temperature and time required for curing. In one arrangement, the moving belt can be an idler belt or a driven belt situated above the conveyor and above the layered component.

As is apparent from the above description, the present invention is able to achieve significant benefits in the area without the use of weights, clamps and rollers, or other physical devices which add additional wear and create potential damage to sensitive components being processed. Further the process is able to recognize improved throughput and speed in processing and further facilitates the deployment of automated equipment into environments that may be dangerous for human intervention. Finally, it is noted that, although specific embodiments have been illustrated and described herein, it will be appreciated by those of ordinary skill in the art that any arrangement calculated to achieve the same purpose may be substituted for the specific embodiments shown. This application is thus intended to cover any adaptations or variations of embodiments of the present invention. As such and therefore, it is manifestly intended that this invention be limited only by the claims.

## Claims

1. A method for connecting a plurality of materials (440, 540) using pressure and thermal curing comprising:
receiving the plurality of materials (440, 540) on a vacuum conveyor (420, 520) at a first location (445, 545), the vacuum conveyor (420, 520) including a plurality of openings through which a predetermined vacuum is applied to hold the plurality of materials (440, 540) in place on the vacuum conveyor (420, 520);
conveying the received plurality of materials (440, 540) from the first location (445, 545) to a second location (455, 555) along the vacuum conveyor (420, 520), a moving belt (415, 515) being adaptively positioned above the vacuum conveyor (420, 520) at the second location (455, 555), and the vacuum conveyor (420, 520) and the moving belt (415, 515) being arranged to be driven in a predetermined relation to one another;
applying a predetermined vacuum through at least one of the plurality of openings to cause the moving belt (415, 515) to apply a pressure to an upper surface of the plurality of materials (440, 540) as the plurality of materials (440, 540) are conveyed from the second location (455, 555) to a third location (465, 565) that compresses the plurality of materials (440, 540); and
thermal curing the compressed plurality of materials (440, 540).

2. The method of claim 1, wherein the moving belt (415, 515) comprises any of an idler belt or a driven belt.

3. The method of claim 1, wherein the plurality of materials (440, 540) comprises at least an upper first portion and a lower second portion arranged to be layered with the upper portion atop the lower portion.

4. The method of claim 3, wherein at least one of the upper portion or the lower portion includes one or more of an adhesive, epoxy or a securing material for securably affixing the upper portion and the lower portion to one another when compressed.

5. The method of claim 1, wherein the second location (455, 555) is a start of a curing step in a manufacturing assembly.

6. The method of claim 1, wherein a supporting plate (430, 575) is positioned beneath an upper conveying portion of the vacuum conveyor (420, 520) for additional support in conveying.

7. The method of claim 1, wherein the moving belt (415, 515) and the vacuum conveyor (420, 520) are operatively controlled by one or more controllers in relation to one another.

8. The method of claim 1, wherein the moving belt (415, 515) and the vacuum conveyor (420, 520) are an integrated unit, a motor drive is common to the vacuum conveyor (420, 520) and the moving belt (415, 515), and the common motor drive is driven by a plurality of gears adaptively arranged.

9. The method of claim 1, wherein the moving belt (415, 515) is driven to control movement in relation to the time and pressure required for cure.

10. The method of claim 1, wherein a speed of conveyance of the vacuum conveyor (420, 520), a speed of operation of the moving belt (415, 515), a material composition of the vacuum conveyor (420, 520), a material composition of the moving belt (415, 515), and a length of travel the vacuum conveyor (420, 520) and the moving belt (415, 515) traverse between the second location (455, 555) and the third location (465, 565) is dependent upon temperature and time required for thermal curing of the plurality of materials (440, 540).

11. The method of claim 1, wherein the plurality of materials (440, 540) comprises one or more materials from the group comprising: Group III-V materials; Group IV materials; Group II-VI materials; Copper indium gallium (di)selenide (CIGS), perovskites, organic semiconductors, CZTS, CZTSSe, and dye-sensitized photovoltaic absorber materials.

12. The method of claim 11, wherein the Group III-V materials comprise any of GaAs, AIGaAs, InGaAs, AllnGaAs, InGaAsP, InGaP, AllnGaP, AllnP or a combination thereof; the Group IV materials comprises any of Si, amorphous Si, Ge, SiGe and or a combination thereof; the Group II-VI materials comprises CdTe; and the perovskites comprise lead halides.

13. The method of claim 1, wherein the plurality of materials (440, 540) comprise one or more photovoltaic cells which are aligned in a matrix.

14. The method of claim 1, wherein the second location (455, 555) is associated with a thermal curing step that comprises application of a thermal source (590), the thermal source (590) being one or more of a conventional oven, a convection oven, a lamp-based thermal source or a resistive heat source.

15. The method of claim 1, wherein the compressed plurality of materials (440, 540) is a finished photovoltaic cell.

## Patentansprüche

1. Verfahren zum Verbinden einer Mehrzahl von Materialien (440, 540) für photovoltaische Zellen unter Verwendung von Druck und thermischer Aushärtung, umfassend:
Aufnehmen der Mehrzahl von Materialien (440, 540) auf einem Saugförderer (420, 520) an einer ersten Stelle (445, 545), wobei der Saugförderer (420, 520) eine Mehrzahl von Öffnungen aufweist, durch die ein vorgegebener Unterdruck angelegt wird, um die Mehrzahl von Materialien (440, 540) auf dem Saugförderer (420, 520) an Ort und Stelle zu halten;
Fördern der aufgenommenen Mehrzahl von Materialien (440, 540) von der ersten Stelle (445, 545) zu einer zweiten Stelle (455, 555) entlang des Saugförderers (420, 520), wobei ein sich bewegendes Band (415, 515) über dem Saugförderer (420, 520) an der zweiten Stelle (455, 555) adaptiv positioniert ist, und wobei der Saugförderer (420, 520) und das sich bewegende Band (415, 515) eingerichtet sind, um in einer vorgegebenen Beziehung zueinander angetrieben zu werden;
Anlegen eines vorgegebenen Unterdrucks durch die Mehrzahl von Öffnungen, um zu bewirken, dass das sich bewegende Band (415, 515) einen Druck auf eine Oberseite der Mehrzahl von Materialien (440, 540) ausübt, wenn die Mehrzahl von Materialien (440, 540) von der zweiten Stelle (455, 555) zu einer dritten Stelle (465, 565) befördert wird, die die Mehrzahl von Materialien (440, 540) komprimiert; und
thermisches Aushärten der komprimierten Mehrzahl von Materialien (440, 540).

2. Verfahren nach Anspruch 1, bei dem das sich bewegende Band (415, 515) ein mitlaufendes Band oder ein angetriebenes Band umfasst.

3. Verfahren nach Anspruch 1, bei dem die Mehrzahl von Materialien (440, 540) mindestens einen oberen ersten Teil und einen unteren zweiten Teil umfasst, die eingerichtet sind, um mit dem oberen Teil auf dem unteren Teil geschichtet zu werden.

4. Verfahren nach Anspruch 3, bei dem der obere Teil und/oder der untere Teil einen oder mehrere Klebstoff(e), Epoxidharz(e) oder ein Befestigungsmaterial enthält, um den oberen Teil und den unteren Teil aneinander sicher zu befestigen, wenn sie zusammengedrückt werden.

5. Verfahren nach Anspruch 1, bei dem die zweite Stelle (455, 555) ein Beginn eines Aushärtungsschrittes in einer Fertigungsanordnung ist.

6. Verfahren nach Anspruch 1, bei dem unter einem oberen Förderabschnitt des Saugförderers (420, 520) zur zusätzlichen Unterstützung beim Fördern eine Stützplatte (430, 575) positioniert wird.

7. Verfahren nach Anspruch 1, bei dem der Betrieb des sich bewegenden Bandes (415, 515) und des Saugförderers (420, 520) in Bezug zueinander durch eine oder mehrere Steuerungen gesteuert wird.

8. Verfahren nach Anspruch 1, bei dem das sich bewegende Band (415, 515) und der Saugförderer (420, 520) eine integrierte Einheit sind, ein Motorantrieb dem Saugförderer (420, 520) und dem sich bewegenden Band (415, 515) gemeinsam ist und der gemeinsame Motorantrieb durch eine Mehrzahl von adaptiv angeordneten Getrieben angetrieben wird.

9. Verfahren nach Anspruch 1, bei dem das sich bewegende Band (415, 515) angetrieben wird, um die Bewegung in Bezug auf die Zeit und den Druck zu steuern, die für die Aushärtung erforderlich sind.

10. Verfahren nach Anspruch 1, bei dem eine Fördergeschwindigkeit des Saugförderers (420, 520), eine Betriebsgeschwindigkeit des sich bewegenden Bandes (415, 515), eine Materialzusammensetzung des Saugförderers (420, 520), eine Materialzusammensetzung des sich bewegenden Bandes (415, 515) und eine Länge des Weges, den der Saugförderer (420, 520) und das sich bewegende Band (415, 515) zwischen der zweiten Stelle (455, 555) und der dritten Stelle (465, 565) zurücklegen, von der Temperatur und der Zeit abhängig ist, die für das thermische Aushärten der Mehrzahl von Materialien (440, 540) erforderlich sind.

11. Verfahren nach Anspruch 1, bei dem die Mehrzahl von Materialien (440, 540) ein oder mehrere Materialien aus der Gruppe umfassend Materialien der Gruppe III-V; Materialien der Gruppe IV; Materialien der Gruppe 11-V1; Kupfer-Indium-Gallium-(Di)selenid (CIGS), Perowskite, organische Halbleiter, CZTS, CZTSSe und farbstoffsensibilisierte photovoltaische Absorbermaterialien umfasst.

12. Verfahren nach Anspruch 11, bei dem die Materialien der Gruppe III-V eines der folgenden Materialien umfassen: GaAs, AlGaAs, InGaAs, AlInGaAs, InGaAsP, InGaP, AlInGaP, AlInP oder eine Kombination davon;
die Materialien der Gruppe IV Si, amorphes Si, Ge, SiGe und/oder eine Kombination davon umfassen; die Materialien der Gruppe II-VI CdTe umfassen; und die Perowskite Bleihalogenide umfassen.

13. Verfahren nach Anspruch 1, bei dem die Mehrzahl von Materialien (440, 540) eine oder mehrere photovoltaische Zellen umfasst, die in einer Matrix ausgerichtet sind.

14. Verfahren nach Anspruch 1, bei dem die zweite Stelle (455, 555) mit einem thermischen Aushärteschritt verknüpft ist, der die Anwendung einer Wärmequelle (590) umfasst, wobei die Wärmequelle (590) ein herkömmlicher Ofen, ein Konvektionsofen, eine Wärmequelle auf Lampenbasis und/oder eine Widerstandswärmequelle ist.

15. Verfahren nach Anspruch 1, bei dem die komprimierte Mehrzahl von Materialien (440, 540) eine fertige photovoltaische Zelle ist.

## Revendications

1. Procédé de connexion d'une pluralité de matériaux (440, 540) en utilisant une pression et un durcissement thermique comprenant les étapes consistant à :
recevoir la pluralité de matériaux (440, 540) sur un transporteur à vide (420, 520) à un premier emplacement (445, 545), le transporteur à vide (420, 520) comportant une pluralité d'ouvertures à travers lesquelles un vide prédéterminé est appliqué pour maintenir la pluralité de matériaux (440, 540) en place sur le transporteur à vide (420, 520) ;
transporter la pluralité de matériaux reçus (440, 540) du premier emplacement (445, 545) à un deuxième emplacement (455, 555) le long du transporteur à vide (420, 520), une courroie mobile (415, 515) étant positionnée de manière adaptative au-dessus du transporteur à vide (420, 520) au deuxième emplacement (455, 555), et le transporteur à vide (420, 520) et la courroie mobile (415, 515) étant agencés pour être entraînés dans une relation prédéterminée l'un par rapport à l'autre ;
appliquer un vide prédéterminé à travers au moins l'une de la pluralité d'ouvertures pour amener la courroie mobile (415, 515) à appliquer une pression à une surface supérieure de la pluralité de matériaux (440, 540) à mesure que la pluralité de matériaux (440, 540) sont transportés du deuxième emplacement (455, 555) à un troisième emplacement (465, 565) qui comprime la pluralité de matériaux (440, 540) ; et
durcir thermiquement la pluralité de matériaux comprimés (440, 540).

2. Procédé de la revendication 1, dans lequel la courroie mobile (415, 515) comprend l'une quelconque parmi une courroie de renvoi ou une courroie entraînée.

3. Procédé de la revendication 1, dans lequel la pluralité de matériaux (440, 540) comprennent au moins une première partie supérieure et une deuxième partie inférieure agencées pour être stratifiées avec la partie supérieure en haut de la partie inférieure.

4. Procédé de la revendication 3, dans lequel au moins l'une de la partie supérieure ou de la partie inférieure comporte un ou plusieurs éléments parmi un adhésif, un époxy ou un matériau de fixation pour fixer solidement la partie supérieure et la partie inférieure l'une à l'autre lorsqu'elles sont comprimées.

5. Procédé de la revendication 1, dans lequel le deuxième emplacement (455, 555) est un début d'une étape de durcissement dans un ensemble de fabrication.

6. Procédé de la revendication 1, dans lequel une plaque de support (430, 575) est positionnée en dessous d'une partie de transport supérieure du transporteur à vide (420, 520) pour un support supplémentaire lors du transport.

7. Procédé de la revendication 1, dans lequel la courroie mobile (415, 515) et le transporteur à vide (420, 520) sont commandés de manière fonctionnelle par une ou plusieurs unités de commande l'un par rapport à l'autre.

8. Procédé de la revendication 1, dans lequel la courroie mobile (415, 515) et le transporteur à vide (420, 520) sont une unité intégrée, un entraînement par moteur est commun au transporteur à vide (420, 520) et à la courroie mobile (415, 515), et l'entraînement commun par moteur est entraîné par une pluralité d'engrenages agencés de manière adaptative.

9. Procédé de la revendication 1, dans lequel la courroie mobile (415, 515) est entraînée pour commander un mouvement par rapport au temps et à la pression requis pour le durcissement.

10. Procédé de la revendication 1, dans lequel une vitesse de transport du transporteur à vide (420, 520), une vitesse de fonctionnement de la courroie mobile (415, 515), une composition de matériau du transporteur à vide (420, 520), une composition de matériau de la courroie mobile (415, 515) et une longueur de trajet que le transporteur à vide (420, 520) et la courroie mobile (415, 515) traversent entre le deuxième emplacement (455, 555) et le troisième emplacement (465, 565) dépend de la température et du temps requis pour le durcissement thermique de la pluralité de matériaux (440, 540).

11. Procédé de la revendication 1, dans lequel la pluralité de matériaux (440, 540) comprennent un ou plusieurs matériaux du groupe comprenant : des matériaux du Groupe III-V ; des matériaux du Groupe IV ; des matériaux du Groupe II-VI ; du diséléniure de cuivre-indium-gallium (CIGS), des pérovskites, des semi-conducteurs organiques, CZTS, CZTSSe et des matériaux absorbants photovoltaïques à colorant.

12. Procédé de la revendication 11, dans lequel les matériaux du Groupe III-V comprennent l'un quelconque parmi GaAs, AlGaAs, InGaAs, AlInGaAs, InGaAsP, InGaP, AlInGaP, AlInP ou une combinaison de ceux-ci ; les matériaux du Groupe IV comprennent l'un quelconque parmi Si, Si amorphe, Ge, SiGe et/ou une combinaison de ceux-ci ; les matériaux du Groupe II-VI comprennent du CdTe ; et les pérovskites comprennent des halogénures de plomb.

13. Procédé de la revendication 1, dans lequel la pluralité de matériaux (440, 540) comprennent une ou plusieurs cellules photovoltaïques qui sont alignées dans une matrice.

14. Procédé de la revendication 1, dans lequel le deuxième emplacement (455, 555) est associé à une étape de durcissement thermique qui comprend l'application d'une source thermique (590), la source thermique (590) étant un ou plusieurs éléments parmi un four classique, un four à convection, une source thermique à base de lampe ou une source de chaleur résistive.

15. Procédé de la revendication 1, dans lequel la pluralité de matériaux comprimés (440, 540) sont une cellule photovoltaïque finie.
